# EUROPÄISCHE PATENTSCHRIFT

(11) **EP 0 502 915 B1**
(45) Veröffentlichungstag und Bekanntmachung des Hinweises auf die Patenterteilung: **14.06.1995**
(21) Anmeldenummer: 90917706.5
(22) Anmeldetag: 30.11.1990
(51) Int. Cl.: C25D 21/12

(54) **Verfahren und Anordnung zur Steuerung des Ablaufes von galvanischen Anlagen**
PROCESS AND DEVICE FOR CONTROLLING THE FLOW OF OPERATIONS IN ELECTROPLATING PLANTS
PROCEDE ET AGENCEMENT DE COMMANDE DU DEROULEMENT D'OPERATIONS DANS DES INSTALLATIONS DE GALVANISATION

(30) Priorität: 01.12.1989 DE 3939681
(43) Veröffentlichungstag der Anmeldung: 16.09.1992
(73) Patentinhaber: ATOTECH Deutschland GmbH, 10553 Berlin (DE)
(72) Erfinder: BLÄSING, Horst, D-1000 Berlin 13 (DE); MAURER, Manfred, D-8548 Heideck (DE); SCHRÖDER, Rolf, D-8501 Burgthann (DE)
(74) Vertreter: Effert, Udo, Dipl.-Ing.
(86) Internationale Anmeldenummer: DE9000943
(87) Internationale Veröffentlichungsnummer: WO9108327

(56) Entgegenhaltungen:
- US-A- 3 880 725
- Patent Abstracts of Japan, Band 6, Nr. 68 (C-100) (946), 30. April 1982; & JP-A-575898

## Beschreibung

Die Erfindung betrifft zunächst ein Verfahren gemäß dem Oberbegriff des Anspruches 1. Bei derartigen horizontalen Durchlaufanlagen, die insbesondere zur Galvanisierung von Leiterplatten verwendet werden, kann es aus irgendwelchen Gründen geschehen, daß die einzelnen, zu galvanisierenden Teile nicht unmittelbar nacheinander, sondern mit einem mehr oder weniger großen Abstand voneinander durch die Anlage transportiert werden. Dies aber hat zur Folge, daß die von den in der Regel oberhalb und unterhalb dieser Förderbahn angeordneten Anoden ausgehende Feldlinien sich dann an den entsprechenden Stirnkanten der durchlaufenden Teile konzentrieren, wenn die Teile einen größeren Abstand voneinander haben, als an sich vorgesehen. Diese Feldlinienkonzentration hat dort ein verstärktes Abscheiden des durch die Galvanisierung aufzubringenden Metalles in Form sogenannter Knospen oder auch in Säulenform zur Folge. Teile, z.B. die oben genannten Leiterplatten, mit derartigen Knospen oder Säulen sind zumindest in ihrer Qualität stark gemindert, wenn nicht unbrauchbar. Das Entfernen solcher Knospen oder Säulen von galvanisierenden Bauteilen ist aufwendig und stets mit der Gefahr einer Beschädigung der im übrigen Bereich des Teiles aufgebrachten Galvanisierschicht verbunden.

In JP-A-575898 ist zwar eine Anordnung mit einem Elektrolysebad, das mit mehreren unabhängig voneinander steuerbaren Anoden ausgestattet ist, offenbart. Die Potentialsteuerung der Elektroden in dieser Anordnung dient dazu, durch Ausschalten einiger Anodenplatten die seitlichen Randbereiche des zu behandelnden und offensichtlich stationären Werkstückes mit Strom aus weiter entfernten Anoden zu versorgen, so daß die durch Feldlinienkonzentration verursachten Randeffekte gedämpft und dadurch gleichmäßige Abscheidungsschichten erhalten werden. Das Dokument betrifft jedoch kein Verfahren zur Steuerung des Ablaufes von galvanischen, horizontal verlaufenden Durchlaufanlagen, bei denen sich die zu behandelnden Werkstücke durch die Anordnung hindurchbewegen, und auch keine Anordnung, mit der dieses Verfahren durchgeführt werden kann.

Die Aufgabe der Erfindung besteht demgegenüber zunächst darin, ein Verfahren gemäß dem Oberanspruch des Anspruches 1 dahingehend zu verbessern, daß auch im Falle unerwünschter Abstände aufeinander folgender, zu galvanisierender Teile unerwünschte, verstärkte Abscheidung an den betreffenden Stirnflächen oder Kanten der Teile vermieden oder zumindest auf einen unschädlichen Wert reduziert werden.

Die Lösung dieser Aufgabe wird zunächst, ausgehend vom Oberbegriff des Anspruches 1, in den Merkmalen des Kennzeichens des Anspruches 1 gesehen. Hiermit können alle Abweichungen der Lage der zu galvanisierenden Teile von den Positionen erfaßt werden, welche die Teile an sich im Hinblick auf Anordnung und Auslegung der Galvanisieranlage besitzen müssen. Entsprechend den vorgenannten Abweichungen, die sich in der Regel in mehr oder weniger großen, unzulässigen Abständen aufeinander folgender Teile äußern, werden die Anoden der Galvanisieranlage so zu- und abgeschaltet, daß trotz der erläuterten Abweichungen die von den Anoden zu den zu galvanisierenden Teilen gehenden Feldlinien in etwa die gleiche Feldliniendichte haben. Hierdurch werden die schädlichen Feldlinienkonzentrationen und die hieraus resultierenden verstärkten Ablagerungen (Knospen u.a.) vermieden.

Der Erfindung liegt ferner die Aufgabe der Schaffung einer Anordnung zugrunde, welche zur Durchführung des Verfahrens nach der Erfindung dient.

Hierzu ist zunächst die Anordnung nach Anspruch 4 vorgesehen. Derartige Erfassungsmittel sind für sich bekannt. Sie können in der erforderlichen Art und Weise und insbesondere an den erforderlichen Stellen angeordnet und ferner in die notwendige Schaltverbindung zu den elektrischen Mitteln gebracht werden, welche die Anoden zu- und abschalten.

Alternativ zur Anordnung nach Anspruch 4 ist zur Lösung der weiter gestellten Aufgabe auch eine Anordnung gemäß Anspruch 5 möglich. Während beim Gegenstand des Anspruches 4 die jeweiligen Bereiche oberhalb und/oder unterhalb der zu- und abzuschaltenden Anoden erfaßt werden, wird mit den Mitteln nach Anspruch 5 eine Erfassung der Lage der zu galvanisierenden Bauteile zueinander an einer einzigen Stelle der Gesamtanlage vorgenommen, bevorzugt an der Stelle, an welcher die Bauteile in die Anlage eintreten. Hierbei muß man die Erfassungsmittel also nur einmal vorsehen. Da im weiteren Verlauf des Transportes der zu galvanisierenden Teile durch die Anlage sich deren Positionen zueinander, insbesondere die Abstände zwischen den Teilen nicht mehr verändern, können die an der betreffenden Stelle erfaßten Positionen in einen Rechner gegeben und auf die Lage der Teile innerhalb der Anlage und damit deren räumliche Zuordnung zu den Anoden während ihres Durchlaufes durch die Anlage ausgerechnet werden. So kann dann z.B. der Verlauf oder das "Bild" eines unzulässig großen Abstandes durch die gesamte Anlage verfolgt und die zugehörigen Anoden immer dann abgeschaltet werden, wenn sich dieser Abstand gerade über oder unter ihnen befindet.

Weitere Vorteile und Merkmale der Erfindung sind den weiteren Unteransprüchen, sowie der nachfolgenden Beschreibung und der zugehörigen, im wesentlichen schematischen Zeichnung zu entnehmen. In der Zeichnung zeigt:
- Fig. 1:: eine galvanische Anlage gemäß dem eingangs geschilderten Stand der Technik in der Seitenansicht und teilweise im Schnitt,
- Fig. 2:: ebenfalls in der Seitenansicht und z.T. im Schnitt eine Anlage nach der Erfindung.

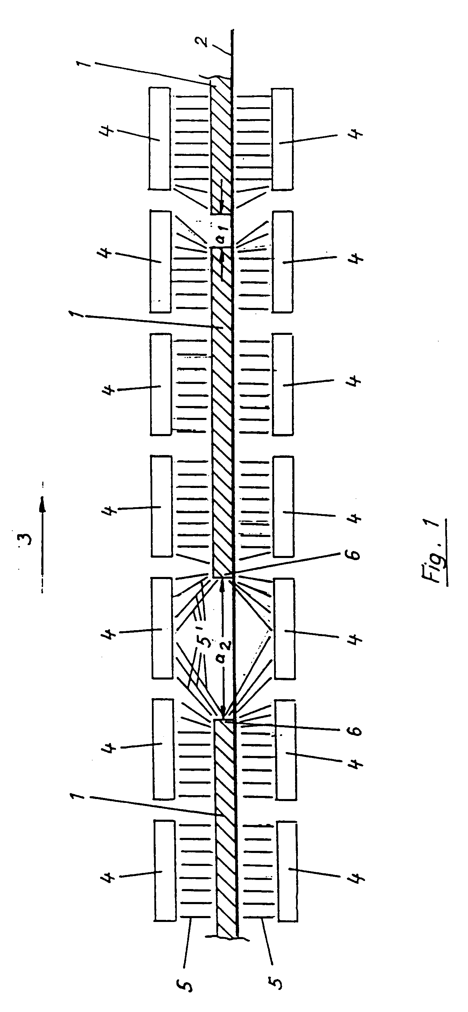

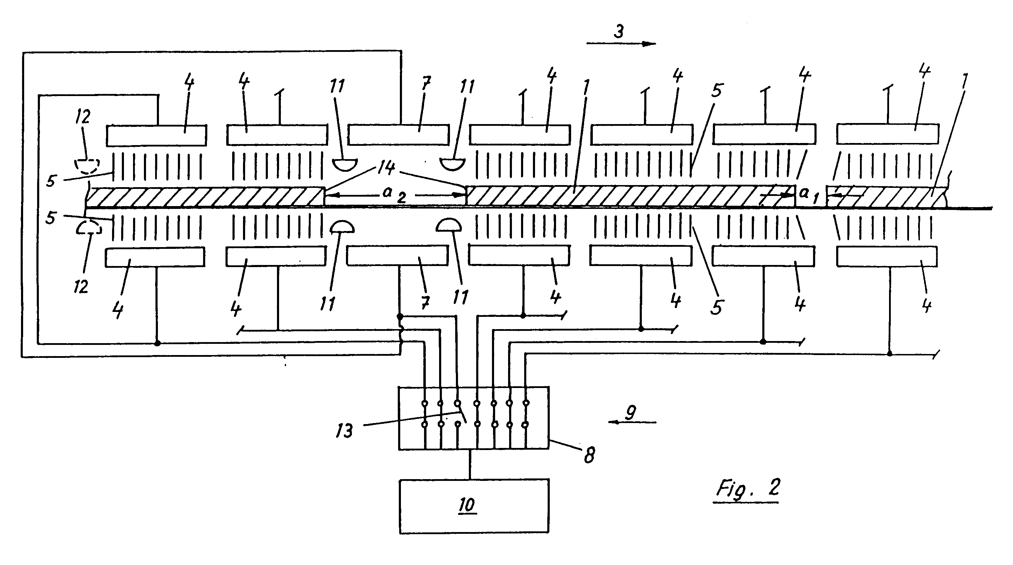

Fig. 1 zeigt das Prinzip einer derartigen bekannten Galvanisieranlage von der Seite her. Die zu galvanisierenden, hier plattenförmigen Teile 1 werden in der Transportebene 2 in der Pfeilrichtung 3 bewegt. Die Transportmittel und auch übrige Bauteile der Anlage sind, da sie nicht zur Erklärung der Erfindung erforderlich sind, in Darstellung und Beschreibung weggelassen worden. Oberhalb und unterhalb der Transportebene 2 befinden sich in Transportrichtung 3 hintereinander in gewissen, nicht allzu großen Abständen Anoden 4, wobei jeweils zwei Anoden übereinander liegend ein Paar bilden, von denen eine Anode sich oberhalb und die andere Anode sich unterhalb der Transportebene befinden. Die Teile 1 sind mit den Anoden 4 derart in einen Gleichstromkreis geschaltet, daß von den Anoden ausgehende Feldlinien durch das Elektrolysebad zu den Teilen 1 führen und dort die Galvanisierung bewirken. Tritt nun der Fall ein, daß hintereinander durch die Anlage laufende Teile 1 nicht den notwendigen, relativ kleinen Abstand a₁, sondern einen demgegenüber größeren Abstand a₂ voneinander haben, so ergibt sich eine unerwünschte Konzentration von Feldlinien 5, 5' an den Kanten oder Stirnflächen 6. Dies rührt daher, daß im Bereich a₂ kein Feldlinien an sich ziehendes oder aufnehmendes Bauteil 1 vorhanden ist. Solche gegenüber a₁ unzulässig große Abstände a₂ können aus verschiedenen Gründen auftreten. Insbesondere in flexiblen, automatisch arbeitenden Galvanisieranlagen mit unterschiedlichen Größen der zu galvanisierenden Teile und ferner mit kleineren Chargen kann es zu diesen unerwünschten größeren Abständen zwischen den einzelnen Teilen kommen. An den Bereichen der Stirnkanten 6 bilden sich dann die erläuterten verstärkten Abscheidungen.
Ist der Abstand zwischen den Teilen 1 gemäß a₁ relativ klein, so tritt zwar noch eine gewisse Feldlinienkonzentration auf (siehe Fig. 1 und 2 rechts), doch ist diese Feldlinienkonzentration so gering, daß sie vernachlässigt werden kann.

Demgegenüber zeigt Fig. 2 das Schema einer Anlage nach der Erfindung, bei der verfahrensmäßig und/auch gerätemäßig die zum vorstehend erläuterten Stand der Technik geschilderten Nachteile vermieden sind. Im Prinzip gleiche Bauteile sind mit der gleichen Bezifferung wie in Fig. 1 versehen. Es sind die Anoden jeweils mit einer Steuereinrichtung 8 zusammengeschaltet, wobei immer die obere und die untere Anode jedes Paares 4, 7 parallel geschaltet sind. Dies ist aus Gründen der zeichnerischen Vereinfachung nur zu dem in Fig. 2 links gelegenen Anodenpaar 4 und zu dem mit 7 bezifferten, nachstehend noch näher zu erläuternden Anodenpaar dargestellt.

Erfassungsmittel, die z.B. optisch, induktiv oder mechanisch arbeiten können, sind schematisch dargestellt und je nach Ausführungsform der Erfindung mit 11 oder mit 12 beziffert.

Die Erfassungsmittel 11 sind - aus Gründen der zeichnerischen Vereinfachung - nur im Bereich des Anodenpaares 7 dargestellt. Sie sind aber bei diesem ersten Ausführungsbeispiel der Erfindung entsprechend bei jedem der weiteren Anodenpaare 4 vorgesehen. Sie erfassen den Raum zwischen den Anoden eines Paares und stellen fest, ob dort ein größerer Abstand a₂ vorhanden ist als zulässig. In diesem Fall bewirken die Erfassungsmittel in zeichnerisch nicht näher dargestellter Weise, daß der entsprechende Schalter 13 des Steuergerätes 8 sich öffnet, wodurch das Anodenpaar 7 von der Gleichstromquelle, hier einem Gleichrichter 10, abgeschaltet und damit stromlos wird. Damit bilden sich zwischen den Anoden 7 dieses Paares keine Feldlinien 5 und es ist die Gefahr der unerwünschten Ablagerungen an den einander gegenüberliegenden, im Abstand a₂ voneinander befindlichen, hier mit 14 bezifferten Stirnkanten der Teile 1 vermieden. Da die Teile 1 in Pfeilrichtung 3 transportiert werden, wird der Abstand a₂ sich anschließend im Bereich des in Pfeilrichtung 3 nächstfolgenden Anodenpaares 4 befinden mit der Folge, daß dann dieses Anodenpaar 4 abgeschaltet und das zuvor stromlose Anodenpaar 7 wieder zugeschaltet wird u.s.w.

Somit wird ein konstanter Feldlinienverlauf 5 erreicht, wie er schematisch dargestellt ist.

Statt der vorgenannten Anordnung der Erfassungsmittel können gemäß einem zweiten Ausführungsbeispiel der Erfindung an der in Fig. 2 links gelegenen Einlaufstelle der Teile 1 in die Anlage gestrichelt dargestellte Erfassungsmittel 12 vorgesehen sein, welche die Abstände zwischen den Teilen bzw. die Position der Teile erfassen und über einen nicht dargestellten Rechner so auswerten, daß bei Entstehen eines unzulässig großen Abstandes (siehe beispielsweise angegebener Abstand a₂) bei Durchlauf der Teile 1 durch die Anodenpaare während des Durchlaufes dieses Abstandes die betreffenden Anodenpaare abgeschaltet und später wieder zugeschaltet werden. Dabei können weitere Daten der Anlage, z.B. die Transportgeschwindigkeit der Teile 1, in den Rechner eingegeben werden, wie es schematisch durch den Pfeil 9 angedeutet ist.

In beiden vorgenannten Fällen erfolgt das Zu- und Abschalten der Anoden segmentweise, d.h. jedes Anodenpaar stellt ein entsprechend zu schaltendes Segment dar.

## Patentansprüche

1. Verfahren zur Steuerung des Ablaufes von galvanischen, horizontal verlaufenden Durchlaufanlagen, durch die die zu galvanisierenden Teile, insbesondere plattenförmigen Teile, nacheinander hindurchlaufen und wobei die Teile mittels über Anoden zugeführte Ströme galvanisiert werden, dadurch gekennzeichnet, daß die Positionen der nacheinander die Anlage durchlaufenden Teile (1) und/oder die Abstände (a₁,a₂) zwischen diesen Teilen erfaßt werden, und daß das Zuführen der Galvanisierströme durch auf diese Positionen und/oder Abstände angepaßte Zu- und Abschalten der Anoden (4,7) derart eingestellt wird, daß die Feldliniendichte an allen Bereichen der Teile (1) etwa gleich groß ist.

2. Verfahren nach Anspruch 1, dadurch gekennzeichnet, daß die Anoden (4,7) in Transportrichtung (3) betrachtet segmentartig zu- und abgeschaltet werden.

3. Verfahren nach Anspruch 1 oder 2, dadurch gekennzeichnet, daß weitere Größen, z.B. die Transportgeschwindigkeit der Teile (1), als Steuergrößen verwendet werden.

4. Anordnung zur Steuerung des Ablaufes von galvanischen, horizontal verlaufenden Durchlaufanlagen, die zur Galvanisierung von insbesondere plattenförmigen Teilen dienen, mit oberhalb und/oder unterhalb der Förderbahn der Teile gelegenen und hintereinander angeordneten, separat schaltbaren Anoden, dadurch gekennzeichnet, daß oberhalb bzw. unterhalb jeder Anode (4,7) Sensoren, Detektoren, optische Mittel oder dergleichen Erfassungsmittel (11) zur Kontrolle der Förderebene (2) der Teile (1) auf das Vorhandensein (oder Nichtvorhandensein) von zu galvanisierenden Teilen vorgesehen sind und daß die Erfassungsmittel in Steuerverbindung mit der Stromzufuhr der Anoden, diese entsprechend zu- oder abschalten, stehen.

5. Anordnung zur Steuerung des Ablaufes von galvanischen, horizontal verlaufenden Durchlaufanlagen, zur Galvanisierung von insbesondere plattenförmigen Teilen, mit oberhalb und/oder unterhalb der Förderbahn der Teile gelegenen und hintereinander angeordneten, separat schaltbaren Anoden, dadurch gekennzeichnet, daß an einer bestimmten Stelle der Anlage, bevorzugt an der Stelle der Einführung der zu galvanisierenden Teile (1) in die Anlage, Erfassungsmittel (12) vorgesehen sind, daß diese Erfassungsmittel in einer Datenverbindung mit einem Rechner stehen, daß der Rechner die Ergebnisse der Erfassung auf die Position und/oder Abstände der Teile (1) während ihres Durchlaufes durch die Anlage umrechnet, und daß der Rechner zugleich die Zu- und Abschaltung des Stromes der Anoden (4,7) der Anlage entsprechend dem Durchlauf der Teile (1) und der Abstände zwischen diesen Teilen steuert.

6. Anordnung nach einem der Ansprüche 4 oder 5, dadurch gekennzeichnet, daß zwischen der Gleichstromquelle, z.B. einem Gleichrichter (10), und den Anoden (4,7) in die Leitungen ein Steuergerät (8) mit je einem Schalter (13) für das Öffnen und Schließen jeder der Leitungen vorgesehen ist und daß die Erfassungsmittel (11,12) oder der Rechner mit den Mitteln zum Betätigen der Schalter (13) in Verbindung stehen.

7. Anordnung nach einem der Ansprüche 4 - 6, dadurch gekennzeichnet, daß jeweils zwei Anoden (4,7) übereinander, und zwar eine Anode oberhalb und die andere Anode unterhalb der Förderbahn (2) der Teile (1) angeordnet sind und daß die Anoden jedes Paares parallel zueinander an die Mittel zum Zu- und Abschalten angeschlossen sind.

## Claims

1. Method of controlling the operating sequence of electroplating, horizontally extending continuous flow systems, through which pass in succession the articles to be electroplated, more especially plate-shaped articles, and wherein the articles are electroplated by means of currents supplied via anodes, characterised in that the positions of the articles (1), passing through the system in succession, and/or the spacings (a₁, a₂) between these articles are detected, and in that the supply of the electroplating currents is adjusted by switching the anodes (4, 7) on and off, said switching operation being adapted to these positions and/or spacings, in such a manner that the flux density is substantially identical in all of the regions of the articles (1).

2. Method according to claim 1, characterised in that the anodes (4, 7) are switched on and off in a segment-like manner when viewed with respect to the direction of travel (3).

3. Method according to claim 1 or 2, characterised in that additional parameters, e.g. the travel speed of the articles (1), are used as control parameters.

4. Arrangement for controlling the operating sequence of electroplating, horizontally extending continuous flow systems, which serve to electroplate plate-shaped articles in particular, having separately switchable anodes, which are situated above and/or below the path of conveyance of the articles and are disposed behind one another, characterised in that sensors, detectors, optical means or similar detection means (11) are provided above or respectively below each anode (4, 7) to monitor the plane of conveyance (2) of the articles (1) for the presence (or non-presence) of articles to be electroplated, and in that the detection means are in control connection with the current supply of the anodes, this connection corresponding to switching-on or -off.

5. Arrangement for controlling the operating sequence of electroplating, horizontally extending continuous flow systems, for electroplating plate-shaped articles in particular, having separately switchable anodes, which are situated above and/or below the path of conveyance of the articles and are disposed behind one another, characterised in that detection means (12) are provided at a predetermined location of the system, preferably at the location where the articles (1) to be electroplated are introduced into the system, in that these detection means are in a data connection with a computer, in that the computer converts the results of the detection to the position and/or spacings of the articles (1) during their passage through the system, and in that the computer simultaneously controls the switching-on and -off of the current of the anodes (4, 7) of the system according to the passage of the articles (1) and the spacings between these articles.

6. Arrangement according to one of claims 4 or 5, characterised in that a control device (8) is provided with a switch (13) in each of the lines for opening and closing each of the lines between the source of direct current, e.g. a rectifier (10), and the anodes (4, 7), and in that the detection means (11, 12) or the computer communicate with the means for actuating the switches (13).

7. Arrangement according to one of claims 4 to 6, characterised in that two anodes (4, 7) at a time are disposed above each other, i.e. one anode being above and the other anode being below the path of conveyance (2) of the articles (1), and in that the anodes of each pair are connected, parallel to one another, to the on-and off-switching means.

## Revendications

1. Procédé de commande du déroulement d'opérations dans des installations de galvanisation en continu, horizontales, à travers lesquelles les pièces à galvaniser, en particulier des pièces en forme de plaques, passent les unes à la suite des autres, et dans lesquelles les pièces sont galvanisées au moyen de courants acheminés par des anodes, caractérisé en ce que les positions des pièces (1) traversant l'installation les unes à la suite des autres et/ou les distances (a1, a2) entre lesdites pièces sont enregistrées, et en ce que l'alimentation en courants de galvanisation est réglé par la connexion et la déconnexion des anodes (4, 7), adaptée auxdites positions et/ou auxdites distances d'une manière telle que la densité des lignes de champ est sensiblement la même dans tous les secteurs des pièces (1).

2. Procédé selon la revendication 1, caractérisé en ce que les anodes (4, 7) sont connectées dans le sens de déplacement (3) et déconnectées par segments.

3. Procédé selon la revendication 1 ou 2, caractérisé en ce que d'autres grandeurs, par exemple la vitesse du déplacement des pièces (1), sont utilisées en tant que grandeurs de commande.

4. Dispositif de commande du déroulement d'opérations dans des installations de galvanisation en continu, horizontales, qui servent à galvaniser des pièces en particulier en forme de plaques, ledit dispositif étant pourvu d'anodes pouvant être connectées séparément qui sont disposées au-dessus et/ou au-dessous de la piste de déplacement des pièces, caractérisé en ce que des capteurs, des détecteurs, des moyens optiques ou des moyens de détection similaires (11), destinés à surveiller la présence (ou l'absence) de pièces à galvaniser dans le plan de transport (2) des pièces (1) sont prévus au-dessus ou en dessous de chaque anode (4, 7), et en ce que les moyens de détection sont en liaison de commande avec l'alimentation en courant des anodes, connectant ou déconnectant ainsi lesdites anodes d'une manière correspondante.

5. Dispositif de commande du déroulement d'opérations dans des installations de galvanisation en continu, horizontales, qui servent à galvaniser des pièces en particulier en forme de plaques, ledit dispositif étant pourvu d'anodes pouvant être connectées séparément, qui sont disposées au-dessus et/ou au-dessous de la piste de déplacement des pièces, et caractérisé en ce que des moyens de détection (12) sont prévus un à certain point de l'installation, de préférence au point où l'on introduit dans l'installation les pièces (1) à galvaniser, et en ce que lesdits moyens de détection sont en liaison informatique avec un ordinateur, en ce que l'ordinateur convertit les résultats de la saisie pour donner la position et/ou les distances entre les pièces (1) pendant leur cheminement à travers l'installation, et en ce que l'ordinateur commande simultanément la connexion ou la déconnexion électrique des anodes (4, 7) de l'installation en fonction du cheminement des pièces (1) et des distances entre lesdites pièces.

6. Dispositif selon l'une quelconque des revendications 4 ou 5, caractérisé en ce qu'un appareil de commande (8) est prévu entre la source de courant continu, par exemple un redresseur de courant (10) et les anodes (4,7), sur les lignes et comporte un interrupteur (13) respectivement pour ouvrir et fermer chaque ligne, et en ce que les moyens d'enregistrement (11, 12) ou l'ordinateur sont reliés aux moyens destinés à actionner les interrupteurs (13).

7. Dispositif selon l'une quelconque des revendications 4 à 6, caractérisé en ce que chaque fois deux anodes (4, 7) sont disposées superposées l'une à l'autre, une anode étant placée au-dessus et l'autre anode en dessous de la piste de transport (2) des pièces (1), et en ce que les anodes de chaque paire sont raccordées parallèlement l'une à l'autre aux moyens de connexion et de déconnexion.
